# EUROPEAN PATENT APPLICATION

(11) **EP 1 565 047 A1**
(43) Date of publication of application: **17.08.2005**
(21) Application number: 05075212.0
(22) Date of filing: 27.01.2005
(51) Int. Cl.: H05K 3/34

(54) **Circuit board surface mount package**

(30) Priority: 10.02.2004 US 775262
(71) Applicant: Delphi Technologies, Inc., Troy, MI 48007 (US)
(72) Inventor: Post, Scott E., Noblesville, IN 46060 (US); Cheok, Cheng Gek, c/o 700 Lorong 1-Toa Payoh, Singapore 319773 (SG); Stillabower, Morris D., Tipton, IN 46072-9111 (US); Nah, Chih Kai, Singapore 510184 (SG); Mandel, Larry M., Noblesville, IN 46060 (US); Yong, Sim Ying, Singapore 550506 (SG)
(74) Representative: Denton, Michael John

(57) **Abstract**

An electronic package (10) is provided having a surface mount electronic device (40) connected to a circuit board (12). The package (10) includes a circuit board (12) and a surface mount electronic device (40). A mounting pad (28) is formed on the circuit board (12). A plurality of vias (30) are formed each having an opening extending into the circuit board (12) and extending through the mounting pad (28). The package (10) further includes a solder joint (32) connecting a contact terminal (42) of the surface mount device (40) to the mounting pad (28) on the circuit board (12). The solder joint (32) extends at least partially into the openings in each of the plurality of vias (30) to support the arrangement of the surface mount device (40) on the circuit board (12).

## Description

### Technical Field

The present invention generally relates to circuit board packages, and more particularly relates to the connection of a surface mount electronic device on a circuit board.

### Background of the Invention

Electronic packages commonly employ a plurality of surface mount electronic devices such as diodes, inductors, capacitors, resistors, varisters, etc., assembled onto a printed circuit board. The printed circuit board generally includes a dielectric substrate (e.g. organic resin reinforced by fibers) and multiple layers of electrically conductive circuit traces. Many circuit boards include perforations for receiving lead lines on lead type surface mount electronic devices which form an electrical connection to the circuit traces.

Lead-less surface mount devices have also been mounted onto printed circuit boards by using surface formed solder joints. However, conventional lead-less surface mount devices have been known to suffer from thermal fatigue in the solder joint, particularly when large surface mount devices are mounted on an organic circuit board and utilized in an environment with high temperature (e.g., +100°C) and/or wide temperature variations (e.g., - 40°C-150°C). The solder joint fatigue is at least partially caused by large differences in the differential coefficients of thermal expansion (CTE) that exist between the circuit board and the surface mount device materials. These differences in thermal expansion can result in catastrophic cracking of brittle components such as surface mount capacitors. Generally, larger components have higher stress and, thus, shorter component life. However, large components are generally desirable because fewer components are required.

Surface mount devices typically have much smaller coefficients of thermal expansion as compared to organic based substrates employed in the circuit board. Temperature fluctuations of the electronic package with continuous power cycles generally produces accumulative fatigue in the solder joints. This accumulative cycle thermal fatigue produces intergranular precipitation and alloy separation in the solder joints which accelerates component breakage. The solder joint fatigue may be accelerated by the presence of vibrations. Additionally, the surface mount devices are typically pulled down tightly to the mounting pads by the action of gravity, soldering, and capillary attraction, thereby resulting in very low collumar compliance. This results in the catastrophic electrical failure of the package due to breakage of the solder joint and/or surface mount device.

Accordingly, it is therefore desirable to provide for an electronic package having a surface mount device to circuit board connection which is less susceptible to thermal fatigue. In particular, it is desirable to provide for such an electronic package that allows for the use of large surface mount devices on a circuit board, that is less susceptible to adverse effects caused by variations in the thermal coefficients of expansion of the materials (e.g., breakage).

### Summary of the Invention

According to one aspect of the present invention, an electronic package is provided having a surface mount device connected to a circuit board. The package includes a circuit board having a substrate and circuitry, and a surface mount device having a contact terminal. A mounting pad is formed on the circuit board. A plurality of vias extend into the circuit board and the mounting pad. Each of the vias has an opening extending through the circuit board and mounting pad. The package further includes a solder joint connecting the contact terminal of the surface mount device to the mounting pad on the circuit board. The solder joint extends at least partially into the opening of each of the plurality of vias to support the arrangement of the surface mount device on the circuit board.

According to another aspect of the present invention, an electronic package is provided having a circuit board connected to a surface mount device. The package includes a circuit board having a substrate and circuitry, and a surface mount device having a contact terminal. A mounting pad is formed on the circuit board. The package includes a via extending into the circuit board and extending through the mounting pad. The via has an opening extending into the circuit board and the mounting pad. The package further includes a solder joint connecting the contact terminal of the surface mount device to the mounting pad on the circuit board. The solder joint extends at least partially into the opening in the via to form a solder column that supports the arrangement of the surface mount device on the circuit board.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a partial perspective view of an electronic package showing a surface mount device in phantom;
FIG. 2 is an enlarged cross-sectional view of the electronic package taken through lines II-II of FIG. 1; and
FIG. 3 is an enlarged cross-sectional view of the electronic package taken through lines III-III of FIG. 1.

### Description of the Preferred Embodiment

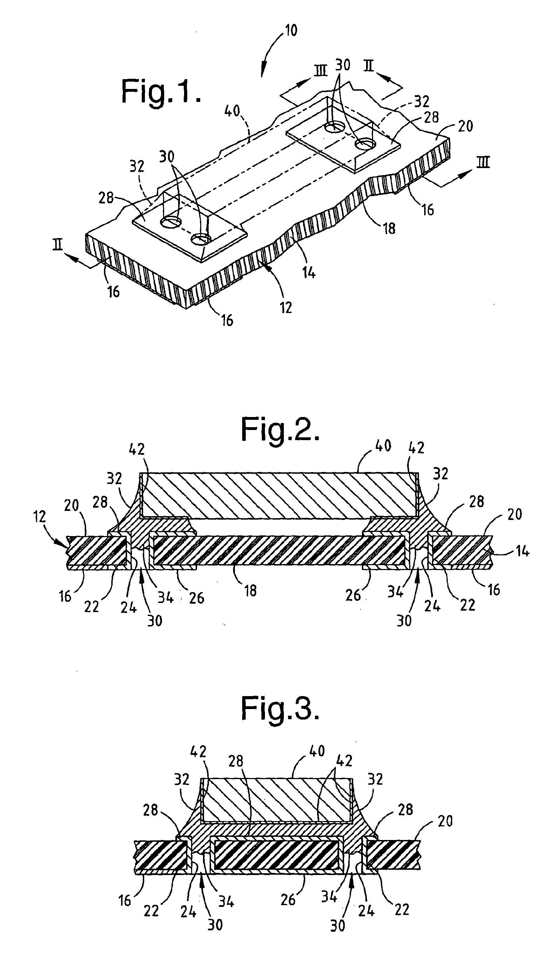

Referring to FIG. 1, an electronic package 10 is generally illustrated having a surface mount electronic device 40, shown in phantom, mounted onto the surface 20 of a circuit board 12. While only a portion of the electronic package 10 is shown and described herein, it should be appreciated that the electronic package 10 may include any number of one or more surface mount devices 40 mounted onto circuit board 12 and connected to circuit board 12 by way of a solder joint interconnection according to the present invention.

The circuit board 12 may include a printed circuit board having a dielectric substrate 14 and electrically conductive circuitry 16 (e.g., printed circuit traces). The circuit board 12 is shown, according to one embodiment, having an upper surface 20 and a lower surface 18, both of which may include electrical circuitry 16 fabricated thereon. However, it should be appreciated that the circuit board 12 may include a laminated circuit board having electrical circuitry 16 located on any of the upper and lower surfaces 20 and 18 and intermediate layers of the dielectric substrate 14. The dielectric substrate 14 of printed circuit board 12 may include an organic-based material such as organic resin reinforced by fibers, according to one embodiment. According to another embodiment, the circuit board 12 may include inorganic material. Examples of circuit board materials may include fire retardant resin, such as FR4, alumina, metal plated plastic, flex on aluminum, porcelainized steel, and other suitable circuit board materials.

Formed on the upper surface 20 of circuit board 12 are electrically conductive mounting pads 28 which serve to mechanically and electrically connect the surface mount electronic device 40 to circuit board 12. Extending through each of the mounting pads 28 and into circuit board 12 are a plurality of electrically conductive vias 30. Each of the conductive vias 30 may be formed by drilling a hole through the conductive mounting pad 28 and into circuit board 12, and then forming an electrically conductive plating on the inner walls of the drilled hole. The electrically conductive plating forming the inner walls of the vias 30 is electrically coupled to the conductive mounting pad 28 and electrical circuitry 16. One example of an electrically conductive plating may include a copper plating.

Referring to FIG. 2, the conductive vias 30 are further illustrated having a conductive inner wall 24 made of a conductive metal plating (e.g., copper). The conductive via 30 is formed having an opening extending through the mounting pad 28 and into circuit board 12. Extending from the conductive via 30 on the lower surface 18 of the circuit board 12 is a conductive layer 26, which may be electrically coupled to electrical circuitry 16 for forming an electrical circuit path. Extending from the conductive via 30 on the upper surface 20 of the circuit board 12 is the conductive mounting pad 28. The conductive vias 30 may extend completely through the circuit board 12 as shown or may extend only partially within circuit board 12.

The surface mount electronic device 40 is shown mechanically connected to printed circuit board 12 and also electrically coupled to printed circuit board 12. The surface mount electronic device 40 may include any of a number of surface mount devices including electronic devices such as a diode, an inductor, a capacitor, a resistor, a varister, as well as other devices that are mechanically mountable on the surface of a circuit board. The surface mount electronic device 40 has contact terminals 42 for providing mechanical support connections and electrical connections to the surface mount device 40. The contact terminals 42 may each include a separate layer of conductive material (as shown) or may include a conductive surface of the electronic surface mount device 40. The contact terminals 42 are mechanically connected to the circuit board 12 by way of a solder joint 32. The solder joint 32 is electrically conductive and serves to form both a mechanical interconnection and an electrical circuit path between the electronic device 40 and circuit board 12.

The interconnection formed by the solder joint 32 at one mounting pad 28 is further illustrated in FIG. 3 with the solder joint 32 shown bonded to both a contact terminal 42 of the surface mount electronic device 40 and the mounting pad 28 on the circuit board 12. The solder joint 32 may include a low temperature eutectic solder that is heated to reflow and form a mechanical bond. In doing so, the eutectic solder is preferably provided on top of the conductive mounting pads 28 and is heated to an elevated temperature such that the solder material transitions from a solid state to a semi-liquid state so that the solder reflows.

The mounting pad 28 may include a solder resist layer (not shown) printed on the upper surface of pad 28 to define a solder window that contains the volume of reflowed solder. During the reflow, the solder is reshaped on the mounting pad 28 and a portion of the solder is able to reflow into the opening in each of vias 30 so as to form a vertical solder column 34 within each via 30. When subsequently cooled, the solder solidifies to form a rigid solder joint 32. By reflowing the solder into vias 30, each of the vertical solder columns 34 are formed in solder joint 32 to provide an enhanced mechanical connection that creates a bending fatigue mechanism, in contrast to a shear fatigue mechanism. The solder joint 32 not only provides an electrical circuit path, but also provides enhanced mechanical connection of the surface mount electronic device 40 to circuit board 12.

According to one embodiment, the package 10 has an aspect ratio of no greater than five (5.0). The aspect ratio is the ratio of the finished circuit board 12 to the finished opening diameter size of the finished vias 30.

In the embodiment shown, two conductive vias 30 are formed extending into the printed circuit board 12 and through mounting pad 28. By forming at least two conductive vias 30 in each mounting pad 28, an enhanced mechanical connection is provided between the surface mount electronic device 40 and the circuit board 12. The formation of two or more vias 30 provides two or more vertical solder columns 34 which may further enhance the bending fatigue mechanism and help prevent sheer fatigue in the solder joint 32 and/or surface mount device 40. While first and second conductive vias 30 are shown formed in each mounting pad 28, it should be appreciated that more than two vias 30 may be formed in each mounting pad 28 to further enhance the strength of the mechanical interconnection.

The solder joint 32 may include any of a number of known solder pastes such as eutectic solder. Examples of commercially available solder pastes include Kester 958 and 951D, Alpha RF 800 and NR 300 A2, and Heraeus F365. According to another embodiment, the solder joint 32 may include conductive adhesives such as polymer-based conductive adhesives.

The circuit board 12 may be fabricated according to any of a number of known circuit board fabrication techniques to create the plurality of conductive vias 30 and the solder joint 32 interconnection as described herein. According to one embodiment, the circuit board 12 may be fabricated by initially adhering plated copper to the upper surface 20 of circuit board 12, photoresisting the plated copper to provide a desired structure to create the desired shape of each of mounting pads 28, forming a photoetch resist on the lower surface 18 of the circuit board 14, photoetching the lower surface 18 of circuit board 14, and leaving the desired electrical circuitry pattern 16 formed thereon. Once the upper mounting pads 28 and lower electrical circuitry 16 are formed on circuit board 12, holes are drilled through the mounting pads 28 extending into the circuit board 12 in the location of the vias 30. This may be achieved by employing a carbon bit drill, according to one example. Once the holes of the via 30 are drilled, the inner walls of the via holes are plated with copper plating to provide vertical reinforced inner side walls that are electrically conductive. The circuit board 12 may then be placed in a plating bath where the copper is deposited to create a copper plating extending between the lower electrical circuitry 16 and the upper mounting pads 28.

In order to connect the surface mount electronic device 40 to the circuit board 12, solder is applied by any of a number of known techniques, such as a fountain wave soldering methodology which is well known in the art. In doing so, the solder is heated to reflow over the mounting pads 28, and then the contact terminals 42 of the surface mount device 40 are placed in the heated solder over corresponding mounting pads 28. The heated solder is reflowed to partially fill the openings in each of the vias 30. Upon cooling, each solder joint 32 solidifies to provide a rigid mechanical interconnection and electrical coupling between the surface mount electronic device 40 and the circuit board 12.

Accordingly, the electronic package 10 of the present invention advantageously provides for an enhanced mechanical strength interconnection of a surface mount electronic device 40 onto a circuit board 12. It should be appreciated that any of a number of various types of surface mount devices 40 may be mounted to a circuit board 12 by employing the teachings of the present invention. By employing the electrically conductive vias 30 and solder joint 32 according to the present invention, enhanced mechanical strength is achieved which allows for use of large circuit boards and surface mount devices to be employed in high temperature (e.g., +100°C) and large temperature variation (-40°C-150°C) environments. The interconnection provided in the resultant electronic package 10 of the present invention is also less susceptible to shear thermal fatigue.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. An electronic package (10) comprising:
a circuit board (12) having a substrate (14) and circuitry (16);
a surface mount device (40) having a contact terminal (42);
a mounting pad (28) formed on the circuit board (12);
a plurality of vias (30) extending into the circuit board (12) and the mounting pad (28), each of the vias (30) having an opening extending therein; and
a solder joint (32) connecting the contact terminal (42) of the surface mount device (40) to the mounting pad (28) on the circuit board (12), wherein the solder joint (32) extends at least partially into the opening in each of the plurality of vias (30) to support the arrangement of the surface mount device (40) on the circuit board (12).

2. The package as defined in claim 1, wherein the plurality of vias (30) comprise a plurality of electrically conductive vias electrically coupled to the circuitry (16) on the circuit board (12).

3. The package as defined in claim 2, wherein each of the plurality of electrically conductive vias (30) comprises a plated copper wall (24).

4. The package as defined in claim 1, wherein the circuit board (12) comprises an organic substrate (14).

5. The package as defined in claim 1, wherein the circuit board (12) comprises a printed circuit board.

6. The package as defined in claim 1, wherein the solder joint (32) comprises solder reflowed at an elevated temperature to at least partially fill each of the plurality of vias (30) to form a column (34) within each of the vias (30).

7. The package as defined in claim 1, wherein the package (10) includes first and second mounting pads (28) each having a plurality of vias (30) extending into the circuit board (12) and each containing a column (34) of the solder joint (32) for supporting the surface mount device (40) on the circuit board (12).

8. The package as defined in claim 1, wherein the surface mount device (40) comprises an electronic device having electrical circuitry.

9. The package as defined in claim 1, wherein each of vias (30) are formed by drilling an opening and plating the opening with an electrically conductive material (24).

10. The package as defined in claim 1, wherein the package has an aspect ratio of circuit board (12) thickness to diameter of the opening of each of the vias (30) of no greater than about 5.0.

11. An electronic package (10) comprising:
a circuit board (12) having a substrate (14) and circuitry (16);
a surface mount device (40) having a contact terminal (42);
a mounting pad (28) formed on the circuit board (12);
a via (30) extending into the circuit board (12) and extending through the mounting pad (28), said via (30) having an opening extending therein; and
a solder joint (32) connecting the contact terminal (42) of the surface mount device (40) to the mounting pad (28) on the circuit board (12), wherein the solder joint (32) extends at least partially into the opening in the via (30) to form a solder column (34) that supports the arrangement of the surface mount device (40) on the circuit board (12).

12. The package as defined in claim 11, wherein the via (30) comprises an electrically conductive via electrically coupled to the circuitry (16) on the circuit board (12).

13. The package as defined in claim 12, wherein the via (30) comprises a plated copper wall (24).

14. The package as defined in claim 11, wherein the circuit board (12) comprises an organic substrate (14).

15. The package as defined in claim 11, wherein the circuit board (12) comprises a printed circuit board.

16. The package as defined in claim 11, wherein the solder joint (32) comprises solder reflowed at an elevated temperature to at least partially fill the via (30) to form a column (34) within the via (30).

17. The package as defined in claim 11, wherein the via (30) comprises first and second vias extending through the mounting pad (28) and into the circuit board (12), wherein the solder joint (32) has a column (34) extending at least partially into each of the first and second vias (30) to further support the arrangement of the surface mount device (40) on the circuit board (12).

18. The package as defined in claim 11, wherein the package (10) includes first and second mounting pads (28), each having a via (30) extending into there through and the circuit board (12) and each receiving solder for supporting the surface mount device (40) on the circuit board (12).

19. The package as defined in claim 11, wherein the via (30) is formed by drilling an opening into the circuit board (12) and plating an electrically conductive material (24) in the opening.

20. The package as defined in claim 11, wherein the surface mount device (40) comprises an electronic device having electrical circuitry.

21. The package as defined in claim 11, wherein the package has an aspect ratio of circuit board (12) thickness to diameter of the opening of each of the vias (30) of no greater than about 5.0.
